Europäisches Patentamt

**(19)** European Patent Office

Office européen des brevets

**(11)** Publication number: **0 246 117**
**A2**

## **(12)** EUROPEAN PATENT APPLICATION

**(21)** Application number: **87304411.9**

**(22)** Date of filing: **18.05.87**

**(51)** Int. Cl.³: **H 01 J 37/20**
**H 01 L 21/68**

**(30)** Priority: **16.05.86 US 864181**

**(43)** Date of publication of application:
**19.11.87 Bulletin 87/47**

**(84)** Designated Contracting States:
**DE FR GB**

**(71)** Applicant: **VARIAN ASSOCIATES, INC.**
**611 Hansen Way**
**Palo Alto, CA 94303(US)**

**(72)** Inventor: **Ballou, Jon M.**
**20 Tulane Road**
**Danvers Massachusetts 01923(US)**

**(72)** Inventor: **Corey, Philip D.**
**8 Patch Avenue**
**Wenham Massachusetts 01984(US)**

**(74)** Representative: **Cline, Roger Ledlie et al,**
**EDWARD EVANS & CO. Chancery House 53-64 Chancery Lane**
**London WC2A 1SD(GB)**

**(54)** Wafer orienter.

**(57)** Apparatus for programmably orienting a semiconductor wafer. The orienting apparatus is employed in an ion implantation system so as to limit channeling or to control the depth of penetration of impinging ions. The apparatus is associated with a processing chamber door and includes a rotatable vacuum chuck for engaging the wafer and a stepper motor for rotating the vacuum chuck and the wafer to a preselected angular orientation. The wafer is first rotated to a selected initial orientation relative to a sensor that senses the passage of an edge of a wafer orienting indentation, typically a wafer flat. The wafer is then rotated through a calculated angular displacement to a desired, preselected angular orientation. The orienting apparatus includes a microprocessor for calculating the angular increment between the initial wafer orientation and the preselected angular orientation. The wafer orientation apparatus may be utilized in a system for the vertical transfer of wafers between a cassette and a processing chamber. The wafer orientation apparatus may also be used in a system wherein wafers are oriented in horizontal transfer system.

FIG.2

## Wafer Orienter

This invention relates to processing of semiconductor wafers and, more particularly, relates to a wafer handling system including apparatus for providing individual wafers with a preselected orientation and to a method for orienting wafers.

Ion implantation has become a standard technique for introducing impurities into semiconductor wafers in a controlled and rapid manner. A beam of ions is generated in a source and directed with varying degrees of acceleration toward the semiconductor wafer. The impurities are introduced into the bulk of semiconductor wafers by using the momentum of the ions as a means of embedding them in the crystalline lattice of the semiconductor material. In bombarding the semiconductor material, it is desirable to carefully control the depth of penetration of the impurity ions so as to control the characteristics of the semiconductor device being fabricated. One factor which determines depth of penetration is the kinetic energy of the impinging ions.

Another factor determinative of depth of penetration is the angle at which the ion beam impinges on the crystalline structure of the semiconductor material, typically silicon. For certain angles of incidence of the ion beam upon the crystalline lattice, it is known that an increase in depth of penetration, referred to as channeling, occurs. The channeling effect arises because rows or planes of atoms can steer energetic ions by means of a correlated series of gentle, small-angle collisions. Since silicon semiconductor wafers are typically cut with a particular crystal axis normal to the surface, it has been the practice in ion implantation to tilt the wafer with respect to the ion beam to avoid channeling effects. Typically, the wafer is tilted so as to provide an angle of about 7 degrees between the ion beam and the normal to the wafer. However, when the wafer is tilted, channeling occurs for certain angles of rotation of the wafer due to rotation of various crystal planes into alignment with the incident ion beam. See, for example, Chu et al, "Backscattering Spectrometry", Academic Press, New York, 1978, pp. 227-228. Therefore, in order to have complete control over the depth of penetration of implanted ions, it is necessary not only to tilt the semiconductor wafer but also to provide a rotational orientation for which channeling is minimal.

One of the major objectives in commercial semiconductor processing is to achieve a high throughput in terms of wafers processed per unit time. To assist in achieving high throughput, automated wafer transfer systems have been developed. These systems typically transfer wafers from a wafer carrier, or cassette, into a wafer processing chamber and then back into the cassette without intervention by an operator. See, for example, U.S. Pat. No. 4,311,427, issued Jan. 19, 1982, to Coad et al, which discloses an automated wafer transfer system for a sputtering system. The wafers in the cassette normally have an unknown rotational orientation when the cassette is introduced into the system. It is therefore desirable to provide such wafer transfer systems with the capability of rotating the wafers into a preselected orientation prior to processing in order to avoid the above-described effects of channeling. It is further desirable that an apparatus for orienting wafers should be simple, low cost, accurate, and fast acting in order to avoid an adverse impact upon the speed and cost of processing wafers.

Apparatus for wafer orientation have been shown in the prior art. U.S. Pat. No. 4,311,427 discloses the use of rotating rollers for aligning the guide flats of wafers in a cassette. U.S. Pat. No. 3,901,183, issued Aug. 26, 1975, to Wittkower, discloses the use of a rotating disk on a wafer holder in a vacuum chamber for aligning the guide flat of a wafer. However, such systems can only align the flat at one predetermined angle. In some wafer processing steps, this limitation is undesirable. The wafer guide flat is not always indicative of the same semiconductor crystal plane. Therefore, simple flat alignment does not always produce the same angle between the crystal lattice and an ion beam. To provide flexibility, the wafer handling system should be programmable to permit any preselected orientation of the wafer. One such system is described in U.S. Pat. No. 4,498,833, issued to Hertel, which is assigned to the assignee of the present invention and which is incorporated herein by reference. The accuracy of the system described in the Hertel patent depends in part on the accuracy of the prealignment of the wafer flat by mechanical roller means. There the inaccuracy in obtaining the desired wafer orientation introduced by the prealignment rollers is typically on the order of $\pm 5°$.

A separate wafer orientation station can be provided between the cassette and the wafer processing chamber. However, such an arrangement adds complexity and cost to the wafer transfer system. Furthermore, the speed of the wafer transfer system is reduced and the risk of wafer damage or breakage is increased

when an additional wafer transfer step is introduced. Finally, errors in wafer orientation can arise as the wafer is transferred from the orientation station to the processing chamber.

It is a general object of the present invention to provide apparatus for orienting a semiconductor wafer prior to processing in a wafer processing chamber.

It is another object of the present invention to provide a simple apparatus for rotating a semiconductor wafer through any preselected angular displacement.

It is yet another object of the present invention to provide apparatus for orienting a semiconductor wafer in an automated wafer transfer system.

It is still another object of the present invention to provide apparatus for orienting a semiconductor wafer at an entrance to a semiconductor processing chamber.

It is still a further object of the invention to provide an apparatus for orienting a wafer whose accuracy does not depend on the accuracy of the mechanical prealignment of the wafer flat by mechanical roller means.

It is another object of the invention to provide a method for orienting wafers.

Summary of the Invention

According to the present invention, these and other objects and advantages are achieved in apparatus for orienting a generally circular wafer in a preselected angular orientation.

In one embodiment the wafer orienting apparatus is used in conjunction with means for positioning the wafer in a wafer processing chamber prior to processing. In this embodiment, the orienting apparatus is associated with a processing chamber door for receiving the wafers and moving the wafers into the processing chamber and includes a rotatable vacuum chuck for engaging the wafer and a stepper motor for rotating the vacuum chuck and the wafer to a preselected angular orientation.

The wafer is first rotated to a selected initial orientation relative to a sensor that senses the passage of an edge of a wafer orienting indentation, typically a wafer flat. The wafer is then rotated through a calculated angular displacement to a desired, preselected angular orientation. The orienting apparatus includes a microprocessor for calculating the angular increment between the initial wafer orientation and the preselected angular orientation.

According to another aspect of the present invention, a system for the automated transfer of generally circular wafers, one at a time, between a cassette holding a plurality of wafers and a wafer processing chamber includes apparatus for providing each of the wafers with any preselected orientation prior to processing. The apparatus comprises wafer handling means associated with an entrance to the wafer processing chamber for receiving a wafer and moving the wafer into the processing chamber. The wafer handling means includes means for engaging the wafer and rotating same to a preselected angular orientation. The apparatus further comprises transfer means for transporting the wafer between the cassette and the wafer handling means and cassette conveyor means for positioning the cassette relative to the transfer means. The apparatus still further comprises means for prealigning a guide flat on each of the plurality of wafers in the cassette.

-6-    0246117

The accuracy of the wafer orienting system disclosed herein does not depend on the accuracy of the prealignment step. In another embodiment the wafer orienting apparatus of the present invention is used independently of a processing chamber door and may be used to orient wafers in a horizontal transport system.

A method for orienting a wafer is described for a wafer having a curve used for orienting the wafer indented into the generally circular periphery of the wafer. This curve is typically a straight line segment (flat) or a V-shaped notch. The wafer is rotated about an axis perpendicular to the plane of the wafer and passing through the center of the wafer. As the wafer is rotated in a first selected direction, a sensor located on one side of the wafer near the periphery of the wafer senses when a first point on the curve indented into the wafer is in register with the sensor. The wafer is then rotated in a second selected direction until the sensor senses a second point on the indented curve. The wafer is then rotated from the initial orientation resulting from the second rotation to a final, desired orientation in a third selected direction about the axis of rotation.

## Brief Description of the Drawings

For a better understanding of the present invention, together with other and further objects, advantages and capabilities thereof, reference may be had to the accompanying drawings which are incorporated herein by reference and in which:

FIG. 1 is a schematic diagram, viewed from above, of an ion implantation system;

FIG. 2 is a simplified side elevation of an automated wafer transfer system in accordance with the present invention;

FIG. 3 is a simplified representation of a portion of the system of FIG. 2 shown with the vacuum chuck retracted;

FIG. 4 is a simplified representation of a portion of the system of FIG. 2 shown with the chamber door in the sealed position;

FIG. 5 is a cross-sectional view of the chamber door and the wafer rotation means in accordance with the present invention;

FIG. 6 is a front view of the wafer and the wafer rotation means in relation to the clamping ring shown in FIG. 5;

FIG. 7a shows an orientation of a wafer wherein the sensor of FIG. 5 does not detect light reflected from the wafer surface;

FIG. 7b shows an orientation of a wafer wherein the sensor of FIG. 5 detects light reflected from the wafer surface;

FIG. 7c shows the orientation of the wafer after the initial orientation has been performed; and

FIG. 8 shows a wafer having a V-shaped notch used in conjunction with the wafer orientation mechanism of the invention.

Detailed Description of the Invention

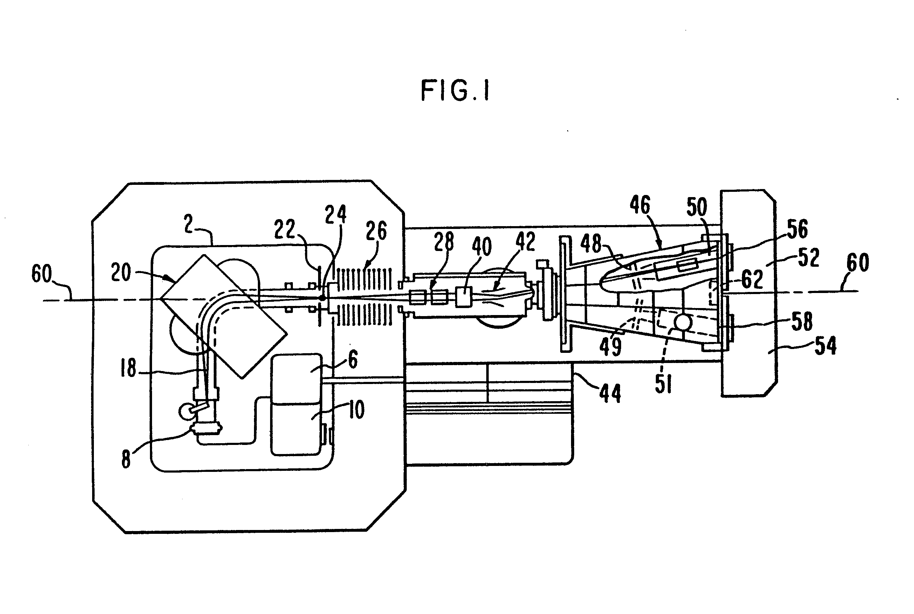

In one embodiment, the wafer orientation system according to the present invention is used in an ion implantation system. An example of an ion implantation system is illustrated in FIG. 1. A high voltage terminal 2 is held at high potential relative to ground by a high voltage power supply (not shown). The terminal 2 houses the apparatus required to form a beam of ions of desired species. In common practice, a gaseous feed stock of the desired species is employed. A source gas produced from a gas handling system 6 is directed to an ion source 8 which is powered by a power supply 10 and provides a high current ion beam 18. Ion source techniques are generally known in the art. The ion beam 18 diverging from the ion source 8 is mass analyzed and focused by an analyzer magnet 20. The analyzed beam passes through a resolving aperture 22 and a variable slit 24 and then through an acceleration tube 26 where it encounters a carefully designed field gradient from the high voltage terminal 2 to ground potential. Optical elements such as a quadru-pole lens 28 operate to produce a spatial energy focus at a target plane. Y deflection plates 40 and X deflection plates 42 provide electrostatic deflection which directs the beam 18 over the area of the target plane. The waveforms applied to the respective deflection plates to form the desired scanning pattern are provided by a scanning system 44.

A dual target chamber 46 includes a housing, beam defining masks 48, 49 and Faraday cages 50, 51 for beam monitoring. Automatic wafer transfer systems 52,54 introduce semiconductor wafers one at a time into the vacuum system in target positions 56,58, respectively, align the same with respect to the target plane, provide cooling of the wafers during implantation and remove the wafers from the vacuum system after implantation is complete. Target positions 56, 58 are typically located within air locks, as described hereinafter, and are displaced horizontally on opposite sides of the longitudinal axis 60 of the undeflected beam 18 such as to require a beam deflection of about ± 7° from the longitudinal axis for scanning thereof. A beam dump 62 is located on the longitudinal axis 60 in the target chamber 46 and intercepts the neutral portion of the ion beam 18.

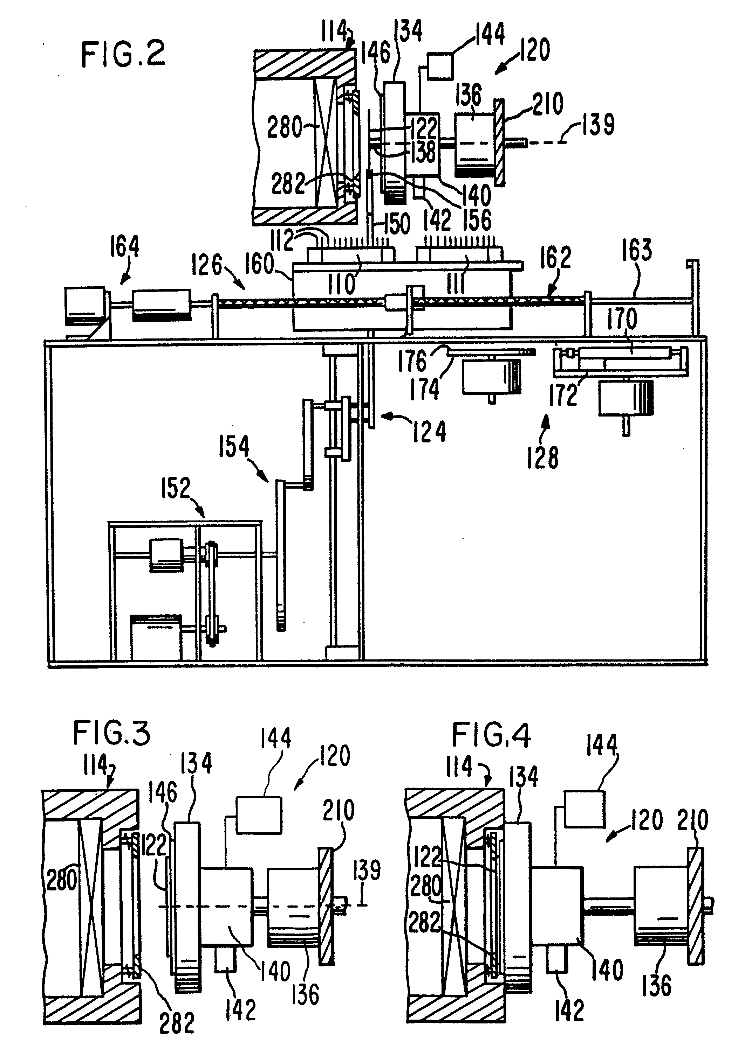

An automated wafer transfer system, corresponding to the systems 52, 54 in FIG. 1, is illustrated in simplified form in FIG. 2. The system automatically transfers generally circular semiconductor wafers, one at a time, between cassettes 110, 111, each holding a plurality of wafers 112, and a wafer processing chamber 114. The cassettes 110, 111 each include a plurality of parallel slots for holding the wafers 112 in an upright, parallel position and are used for transporting and temporarily storing the wafers 112. The cassettes 110, 111 are typically a plastic material and, in the system of FIG. 2, must have open bottoms to provide access to the wafers 112 from below. The wafer processing chamber 114 is a vacuum chamber and in the present example is an end station for serial ion implantation of wafers.

The wafer transfer system shown in FIG. 2 includes wafer handling means 120 associated with an entrance to the processing chamber 114 for receiving a wafer 122 and moving the wafer 122 into the processing chamber 114. The transfer system further includes transfer means 124 for transporting the wafer 122 between the cassettes 110, 111 and the wafer handling means 120 and cassette conveyor means 126 for positioning the cassettes 110, 111, relative to the transfer means 124. The system still further includes means 128 for prealigning a guide flat on each of the plurality of wafers 112 in the cassettes 110, 111.

The wafer handling means 120 includes a chamber door 134, means 136 for moving the chamber door 134 linearly along longitudinal axis 139 of vacuum chuck 138 between an open position, as shown in FIG. 2, and a sealed position, as shown in FIG. 4, and means for engaging the wafer 122 and rotating it to a preselected angular orientation relative to an initial orientation associated with a wafer flat. The means for engaging the wafer 122 and rotating it includes a rotatable vacuum chuck 138, means enclosed within a housing 140 for moving the vacuum chuck 138 linearly along longitudinal axis 139 between a wafer-receiving position, as shown in FIG. 2, and a retracted position, as shown in FIG. 3, and means for rotating the vacuum chuck 138 to an initial angular orientation and from the initial orientation to the preselected desired angular orientation. The means for rotating the vacuum chuck 138 includes a stepper motor 142 coupled to the vacuum chuck 138 and a programmable microprocessor not shown) which drives a motor controller 144 coupled to motor 142, as described in detail hereinafter. The chamber door 134 typically includes a wafer-receiving surface, or platen 146, against which the wafer 122 is held during processing and means (not shown) for cooling the platen 146.

The transfer means 124 includes an elevator blade 150, drive means 152 and crank means 154 coupling the drive means 152 to the elevator blade 150 and converting the rotary motion of the drive means 152 to linear blade 150 motion. The drive means 152 typically includes a motor and a mechanical stepper. The elevator blade 150 has an arcuate leading edge provided with a groove 156 adapted to engage edgewise a wafer in the cassettes 110, 111 from below and raise the wafer to the wafer handling means 120.

The cassette conveyor means 126 includes a cassette holder 160 coupled to a ball reverser 162 positioned on one side and to a guide shaft 163 positioned on the opposite side of the holder 160. The conveyor means 126 further includes drive means 164 for actuating the ball reverser 162 and stepwise or continuously moving the holder 160 along a linear path. The drive means 164 typically includes a motor, a slip clutch and a mechanical stepper.

The means 128 for prealigning the guide flat on each of the wafers 112 includes a roller 170 positioned below the cassettes 110, 111 so as to simultaneously contact the edges of all the wafers 112 in one of the cassettes 110, 111. The roller 170 is in the form of a cylinder which can be rotated by a motor 172 coupled thereto and is movable upward to an alignment position and downward to a retracted position. The axis of the roller 170 is aligned with the long dimension of the cassettes 110, 111. The means 128 for prealigning can further include an element 174 with a flat surface 176 positioned below the cassettes 110, 111. The element 174 is movable upward to an alignment position in which the flat surface 176 contacts the wafers 112 and downward to a retracted position. The element 174 is moved upward and downward by an actuating means 178, such as an air cylinder. For additional information relating to the automated wafer transfer system illustrated in FIG. 2, reference is made to US-A-4449885.

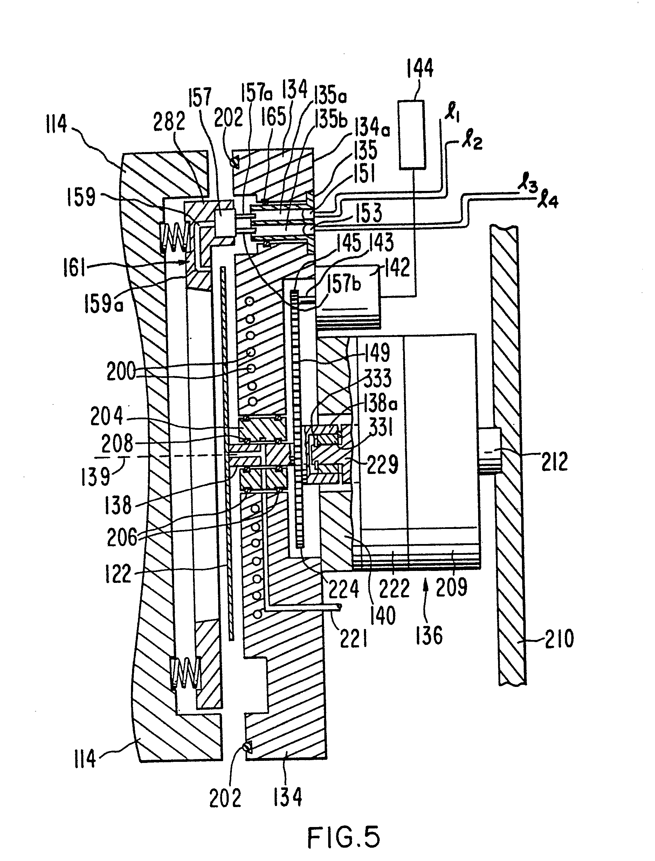

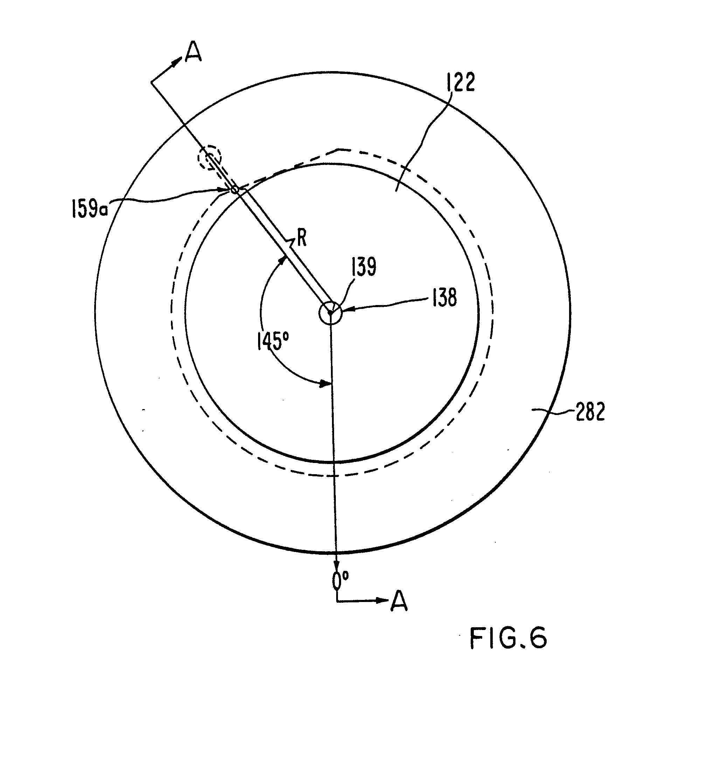

Referring now to FIG. 5, which is a cross-section along the line A-A shown in FIG. 6, there is shown a cross-sectional view of the wafer handling means 120. The chamber door 134 includes the platen 146 which can be convexly curved and which can be covered with a pliable, thermally conductive material to improve contact between the wafer 122 and the platen 146 as described in US-A-4282924, issued Aug. 11, 1981, to Faretra. Sensor 161 includes emitter-detector housing 135, a cylindrical housing extending from back surface 134a of door 134 through door 134 and rigidly attached thereto.

Housing 135 has cylindrical passageways 135a and 135b passing therethrough. Emitter 151 and detector 153 are attached by epoxy to housing 135 in passageways 135a and 135b, respectively, forming vacuum seals so that no air can pass through these passageways. Emitter 151 is a light emitting diode and detector 153 is a photodetector which, for example, may be purchased from Dolan-Jenner. Leads $\ell_1$ and $\ell_2$ are connected between the anode and cathode, respectively, of emitter 151 and a source board (not shown) which may also be purchased from Dolan-Jenner. Leads $\ell_3$ and $\ell_4$ are connected between detector 153 and the source board. When door 134 is in its retracted position shown in FIG. 5, emitter 151 is continuously energized by a signal from a microprocessor (not shown).

Tube 159 contains a bifurcated fiber-optic bundle containing fibers of two types. The first type of fiber extends from end 159a of tube 159 into housing extension 157a of housing 157 and transmits the infrared signals received from emitter 151 via passageway 135a to end 159a. End 159a of sensor 161 is directed normal to the surface of wafer 122. The second type of fiber extends from end 159a of tube 159 into housing extension 157b and transmits the infrared pulses reflected back from the surface of wafer 122 to photodetector 153 via passageway 135b. The signal from photodetector 153 is provided to a microprocessor. The bifurcated fiber-optic bundle in tube 159 has a diameter of 0.68mm and the two types of fibers are randomly distributed in the bundle. Such a bifurcated randomized fiber-optic bundle is available, for example, from Dolan-Jenner. Typically the wafer 122 has a major flat and one or more minor flats and in one embodiment of the invention, the end 159a of tube 159 is positioned in clamp ring 282 relative to the edge of wafer 122 so that if wafer 122 is rotated through one complete revolution with vacuum chuck 138, the infrared pulses emanating from end 159a will be reflected back from the surface of wafer 122 except for a period of time as the major flat is rotated past fiber-optic sensor end 159a. Elastomeric O-ring 165 seals housing 135 against door 134.

Chamber door 134 can also include passages 200 for the circulation of a cooling fluid. Alternatively, it will be realized that, in some cases, cooling of the wafer 122 at the chamber door 134 will not be required. For example, the process may not employ high power or the wafer 122 may be transferred away from the chamber door to another position in the processing chamber 114 for processing, as shown in US-A-4311427. In this case, the platen 146 and the cooling passages 200 are not included in the chamber door 134.

An O-ring 202 is provided around the periphery of the chamber door 134 to seal the chamber door against the entrance to the wafer processing chamber 114. The chamber door 134 is further provided with a bushing 204 through which the vacuum chuck 138 passes. The bushing 204 is sealed against the chamber door 134 by a pair of O-rings 206 and against the vacuum chuck 138 by a pair of O-rings 208. The vacuum chuck 138 has a passage through which air is drawn via tube 221 to provide suction. The housing 140 is attached to the rear of the chamber door 134. The means 136 for moving the chamber door 134 includes a pancake cylinder 209 attached to a second pancake cylinder 222, both of which are bolted to door 134 by bolts (not shown). The shaft 212 of pancake cylinder 209 is attached to rigid frame member 210. The pancake cylinders are typically air driven and are actuated to move the chamber door 134 linearly along longitudinal axis 139 of vacuum chuck 138 between the position shown in FIG. 2 and the position shown in FIG. 4.

Means 222 for moving the vacuum chuck 138 between the wafer-receiving position and the retracted position is mounted to door 134 behind the vacuum chuck 138 via bolts (not shown). The air driven shaft 229 of pancake cylinder 222 is inserted in bushing 331 which is attached to lower portion 138a of vacuum chuck 138. Bushing 331 allows rotation of chuck 138 about axis 139. Retaining ring 333 prevents shaft 229 from coming out of bushing 331. Vacuum chuck 138 is attached to shaft 229 and therefore moves linearly along axis 139 as shaft 229 moves linearly along axis 139. The means for rotating the vacuum chuck 138 includes stepper motor 142 which is attached to door 134, pulley 224 and belt 149. The microprocessor (not shown) drives a motor controller 144 for microstepping motor 142 so that motor shaft 143 makes one complete revolution of 360° in 400 steps. Gear 145 turns with shaft 143 and drives pulley 224 attached to vacuum chuck 138 via belt 149. Belt 149

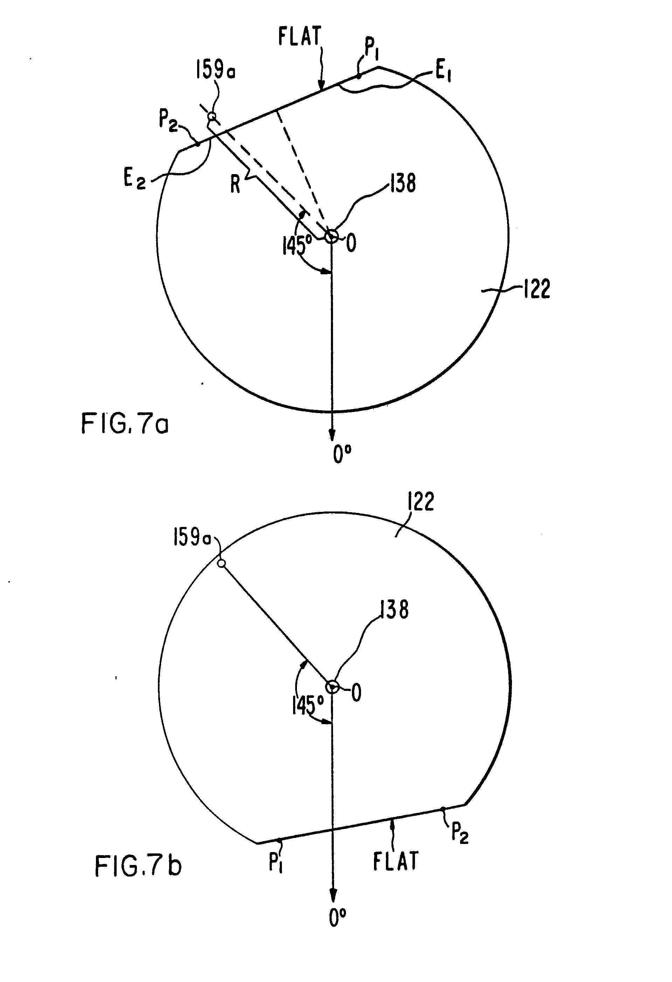

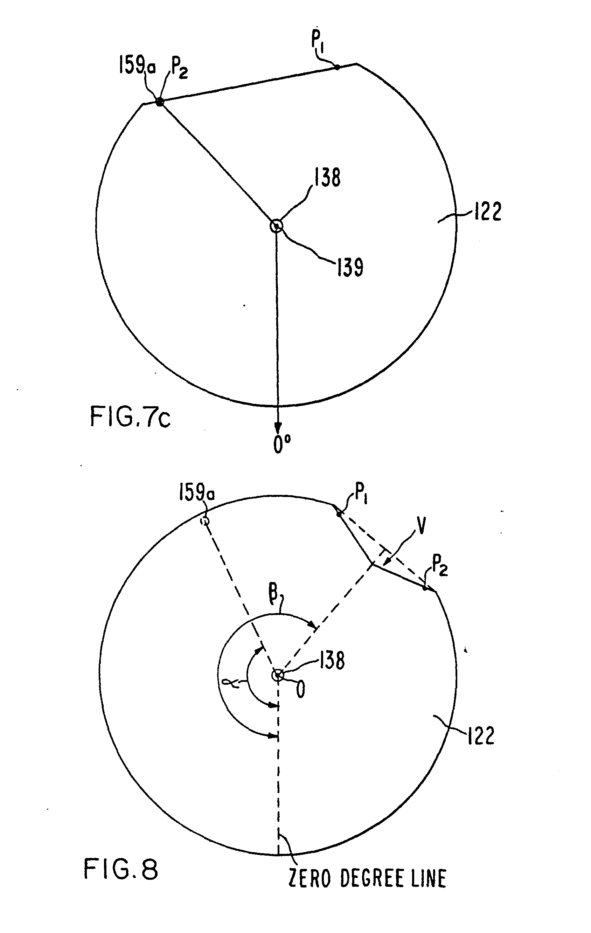

is flexible enough to allow the position of gear 145 to remain fixed while pulley 224 translates with vacuum chuck 138. Gear 145 and pulley 224 are dimensioned so that gear 145 makes 3.6 revolutions of 360° in order to drive pulley 224 through one revolution of 360°. Thus, each step of motor shaft 143 causes a rotation of 1/4° of vacuum chuck 138 (and of wafer 122 attached thereto). A motor step is said to be a clockwise step if it causes wafer 122 (FIG. 7) to rotate in a clockwise direction and a counter-clockwise step if it causes wafer 122 to rotate in a counter-clockwise direction.

As shown in FIG. 6, for the operation of the microprocessor (not shown), an angular coordinate system is established having its origin at the center of the end of vacuum chuck 138 which engages wafer 122. The zero degree ray (half-line) emanating from the origin lies in the plane perpendicular to the axis of rotation 139 of vacuum chuck 138. Its direction in this plane may be selected as desired and in one embodiment is selected as the ray pointing vertically downward from the origin. The end 159a of fiber-optic sensor 161 may be positioned at any convenient angular position around the inner periphery of clamp ring 282. In one embodiment end 159a of sensor 161 is positioned so that the clockwise angle from the ray (half-line) which issues from the origin and which passes through the center of the infrared pulse beam from end 159a of sensor 161 to the zero degree ray is 145°.

The operation of the wafer transport system described hereinabove will be explained with reference to FIGS. 2-7c. It will be realized that the automated operation of the wafer transfer system described herein is controlled by a system controller (not

shown) which actuates each mechanism at a prescribed time and for a prescribed duration. The controller can be a dedicated electronic controller or can be a computer operating through appropriate interface circuits.

Initially, an operator places cassettes 110, 111 in the cassette holder 160 positioned at the right end (FIG. 2) of the cassette conveyer means 126 and initiates operation of the system. The cassette 110 is moved by operation of the ball reverser 162 and the drive means 164 to a position above the roller 170. The roller 170 is moved upward to the alignment position and is rotated. The rotation of the roller 170 causes rotation of each of the wafers 112 until its guide flat is tangent to the roller 170 at the bottom of the cassette 110. Next, the roller 170 is retracted and the cassette 110 is moved to a position above the element 174 which is then moved upward to the alignment position. The flat surface 176 slightly lifts each of the wafers 112 and then is lowered, thus causing the guide flat of each of the wafers 112 to be accurately positioned at the bottom of the cassette 110. The operation of the element 174 removes minor variations in guide flat alignment remaining after operation of the roller 170.

The cassette 110 is next moved by the cassette conveyor means 126 to a position in which one of the wafers 112 is directly above the elevator blade 150. The blade 150 is raised by operation of the drive means 152 and the crank means 154 until it contacts the wafer 122 from below and engages edgewise the wafer 122 in the groove 156. The blade 150 moves upward through the cassette 110 and lifts the wafer 122 to a position adjacent the open chamber door 134, as shown in FIG. 2. The microprocessor stops the upward motion of the blade when the center of the wafer is opposite the center of vacuum chuck 138. This stopping point is determined by the nominal diameter of the wafers transported by blade 150. Due to small variations in wafer diameter from the nominal diameter, there are small variations in the accuracy with which vacuum chuck 138 engages the center of wafer 122, but the orientation process described below is not substantially sensitive to these small variations. The vacuum chuck 138 is extended outwardly from the chamber door 134 to a wafer-receiving position and holds the wafer 122 through operation of vacuum suction upon the rear surface of the wafer 122. The elevator blade 150 is then lowered. FIG. 2 illustrates the operation at the point when the wafer 122 is transferred to the vacuum chuck 138.

Before the vacuum chuck 138 is retracted or the chamber door 134 is moved to the sealed position, the wafer 122 is rotated to the desired orientation.

First the operator inputs to the microprocessor (not shown) the preselected (desired) angular orientation of the perpendicular bisector of the wafer flat as measured clockwise from the zero degree ray shown in FIG. 6. (This perpendicular bisector passes through the center of wafer 122.)

Sensor 161 is activated, and an initial orientation of the perpendicular bisector of the wafer flat is determined in response to an orient command as follows. There are two cases.

Case 1: (Illustrated by FIG. 7a). When the orient command is issued, the level of the voltage signal produced by detector 153 indicates that infrared pulses are not being reflected from the surface of wafer 122. In this case, a search for a first

edge crossing point $P_1$ (on one side of the flat perpendicular bisector) is initiated by activating stepper motor 142 to rotate wafer chuck 138 and wafer 122 counter-clockwise. This counter-clockwise rotation continues until an edge crossing point or transition is detected by the voltage signal from detector 153 indicating that an infrared pulse is reflected from the surface of wafer 122 or until wafer 122 has been rotated 90° counter-clockwise without an edge being detected, whichever occurs first. Each counter-clockwise step corresponds to a counter-clockwise rotation of 1/4° of wafer 122.

If no edge crossing point is detected, after 90°, the microprocessor signals a system fault, i.e., that no wafer was present in blade 150.

Otherwise, having found a first edge crossing point $P_1$ on edge $E_1$, a search is initiated for a second edge crossing point $P_2$ for edge $E_2$ by stepping motor 142 "clockwise" so that vacuum chuck 138 and wafer 122 rotate clockwise. Each "clockwise step" corresponds to a clockwise rotation of 1/4°. This clockwise rotation continues until a second edge crossing point $P_2$ on edge $E_2$ is detected or until wafer 122 has been rotated clockwise 90° without a second edge crossing being detected. If no second edge crossing is detected after a 90° rotation, the microprocessor signals that either the flat is too long or the wafer is broken. When the second edge crossing point $P_2$ on edge $E_2$ is detected, the signed number of steps to the second edge crossing search is recorded (+ for clockwise - for counter-clockwise) and the initial orientation in motor steps of the perpendicular bisector of the wafer flat from the zero degree line is determined by the formula:

(1) initial orientation = Number of clockwise motor steps corresponding to the 145° angle
between the zero degree ray and the ray (half-line)
which issues from the origin and passes through the
center of the infrared pulse beam from end 159a of
sensor 161 plus the number of clockwise steps in the
search for the second edge crossing point divided
by 2.

Having determined the initial orientation of
the perpendicular bisector of the wafer flat (in
motor steps) according to the above formula, the
microprocessor compares the preselected (desired)
angular orientation of the perpendicular bisector
of the wafer flat (in signed motor steps) with the
initial orientation in signed motor steps described
above and determines whether the desired orientation
can be obtained from the present initial orientation
in fewer steps by a counter-clockwise rotation or a
clockwise rotation and then rotates the wafer in the
appropriate direction through the required number of
steps to orient the perpendicular bisector of the
wafer flat in the desired orientation.

The orientation is now completed.

Case 2: (Illustrated by FIG. 7b). When the
orient command is issued, the voltage signal produced
by detector 153 indicates that the infrared pulses
are being reflected from the surface of wafer 122.

In this case, a search is initiated, looking
for a first edge crossing point, by activating
stepper motor 142 to rotate wafer chuck 138
and wafer 122 clockwise. This clockwise rotation
is continued until a first edge crossing point is
detected by the voltage signal from detector 153
indicating to the microprocessor that an infrared
pulse is no longer reflected from the surface of wafer 122 or until wafer 122 has been rotated clockwise by 360° with no edge crossing point being detected.

In the latter event, the microprocessor signals a fault indicating that no flat is present. If a first edge crossing point is detected, a search is then initiated for a second edge crossing point by stepping motor 142 so that vacuum chuck 138 and wafer 122 continue to rotate clockwise until a second edge crossing point is detected. (If this does not occur after a clockwise rotation of 90°, the microprocessor signals that either the flat is too long or the wafer is broken.)

When the second edge crossing point is detected, the signed number of motor steps is recorded and the initial orientation of the perpendicular bisector of the wafer flat is determined by formula (1) given above.

The number of clockwise steps in the search for the second edge crossing divided by 2 represents 1/2 of the angle swept out as the wafer rotates past the sensor end 159a from the first edge crossing point to the second edge crossing point.

In both case 1 and case 2, the initial orientation of the wafer rotates the wafer to the position shown in FIG. 7c with the second crossing point on the edge of the wafer flat in register with end 159a of sensor 161. Having rotated the wafer to its initial orientation, the wafer is then rotated to its desired orientation. This final orientation is specified in degrees from the zero degree ray to the desired location of the perpendicular bisector of the wafer flat. The microprocessor converts the degrees to motor steps.

After orientation of the wafer 122 by rotation of the vacuum chuck 138, the vacuum chuck 138 is retracted into the chamber door, as shown in FIGS. 3 and 5, by operation of the air cylinder 222. By continuous application of vacuum to the vacuum chuck 138, the wafer 122 is held against the platen 146 even after the vacuum chuck 138 has been retracted into the chamber door 134, since the seal is maintained by the O-rings 208.

Next, the air cylinder 136 is actuated so as to move the chamber door 134 to the sealed position, as shown in FIG. 4. The O-ring 202 provides sealing of the wafer processing chamber 114. An air lock adjacent to the chamber door 134 is typically isolated from the main volume of the processing chamber by a vacuum gate valve 280 when the chamber door 134 is opened. The air lock minimizes the volume required to be vacuum pumped after the chamber door 134 is sealed. After the chamber door 134 is sealed, the air lock is evacuated, the vacuum gate valve 280 is opened and processing of the wafer proceeds. The wafer 122 is firmly clamped around its periphery against the platen 146 by a spring-loaded wafer clamping ring 282. Peripheral clamping of the wafer 122 insures good thermal contact between the wafer 122 and the platen 146. In the present example, the processing of the wafer 122 involves scanning of a focused ion beam over the wafer surface in a uniform, repetitive pattern to provide a prescribed uniform dosage of impurities in the material of the semiconductor wafer 122.

When the processing of the wafer 122 has been completed, the vacuum gate valve 280 is closed and the chamber door 134 is opened by actuation of the air cylinder 136. The vacuum chuck 138 is then extended without rotation by operation of the air cylinder 222. The vacuum chuck 138 engages the wafer and then rotates the wafer so that the perpendicular bisector of the wafer flat is aligned with the zero degree ray. The elevator blade 150 is raised until the groove 156 engages the wafer 122. At this time the vacuum chuck 138 releases the wafer 122 and is retracted into the chamber door 134. The elevator blade 150 lowers the wafer 122 into the same position in the cassette 110 from which it originally came. The elevator blade 150 is moved to its lowered position below the cassette 110, and the cassette 110 is indexed by the cassette conveyor means 126 to the next wafer position. The elevator blade 150 raises the next wafer to the chamber door 134, and the process is repeated as described hereinabove. When each of the wafers 112 in the cassettes 110, 111 has been processed in accordance with this procedure, the cassettes 110, 111 are moved back to the right by the cassette conveyor means 126 for removal by the operator.

While the wafer orientating system described above has been explained in connection with an ion implantation system, it has broader application for orientating a wafer which is rotatable about its center by a means affixed to its center. In other embodiments the clamping ring 282 is not present, and the sensor 161 may be supported by any suitable means so that the end 159a of the sensor 161 is directed approximately normal to the surface of the wafer. Sensor 161 is described as a sensor which detects reflected light. Sensor 161 in other embodiments has an energy emitter positioned at location 159a on one side of the plane of the wafer and an energy detector positioned opposite the energy emitter on the other side of the plane of the wafer. Similarly, while the orientation process has been described in terms of a wafer having a major flat, the flat shown in FIGS. 7a and 7b, which is a special case of an indented curve used for orienting the wafer, may be replaced by another wafer alignment curve indented into the wafer such as a v-shaped groove as shown in FIG. 8. The indented curve may also be a semicircular notch. Again, the initial orientation of the wafer is determined by rotating the wafer to detect the crossing points $P_1$ and $P_2$, recording the number $N_1$ of signed steps required to rotate the wafer from a first edge crossing point $P_1$ to a second edge crossing point $P_2$, and adding 1/2 of $N_1$ (adjusted for the software loop if necessary) to the number $N_2$ of signed steps associated with the angle alpha in the plane of the wafer between the zero degree ray and the ray from the center of the wafer to the point where the beam from the sensor emitter passes through the wafer. The $N_1/2$ steps correspond to one-half of the angle swept out as the wafer rotates from crossing points $P_1$ to $P_2$.

By choosing the coordinate system so the zero degree ray passes through this latter point (where the beam of the sensor passes through the plane of the wafer), the angle alpha is 0° and the associated number of steps is zero. If beta represents the desired angular orientation of the line bisecting the groove V, the wafer is rotated to this desired angular orientation by first rotating the wafer to its initial orientation described above and then rotating the wafer from its initial orientation through the angle between its initial orientation and its desired orientation.

## Claims

1.  A wafer alignment system comprising:

means for gripping a wafer and for rotating said wafer about an axis perpendicular to the plane of said wafer and approximately passing through the center of said wafer, said wafer having a curve indented into the generally circular periphery of said wafer;

means, positioned near the periphery of said wafer, for sensing a first edge crossing point on said indented curve and a second edge crossing point on said indented curve as said wafer is rotated past said means for sensing; and

means for computing including

means for calculating the angle swept out as said wafer is rotated in a selected direction so that said means for sensing senses said first edge crossing point and then senses said second edge crossing point;

means for adding a selected fraction of said angle to an angle corresponding to the angular orientation of the line segment from the center of said wafer to a point where a beam from said sensing means passes through the plane of said wafer so that an initial angular orientation of said wafer is determined; and

means for determining the angular increment between said initial angular orientation and a preselected angular orientation of said wafer.

2.  A wafer alignment system as in claim 1 wherein said selected fraction is one-half.

3. An apparatus for orienting a wafer having an curve indented into the generally circular periphery of said wafer comprising:

a sensor;

means for positioning said wafer so that said sensor is located on one side of a planar surface of said wafer near said periphery;

means for rotating said wafer in a first selected direction about an axis perpendicular to said planar surface, said sensor sensing when a first point on said indented curve is in register with said sensor; and

means for rotating said wafer in a second selected direction about said axis, said sensor sensing when a second point on said indented curve is in register with said sensor.

4. An apparatus as in claim 3 wherein said sensor comprises a bifurcated fiber-optic bundle.

5. An apparatus as in claim 3 wherein said means for positioning includes means for locating said wafer so that said axis passes through the center of said wafer.

6. An apparatus as in claim 3 wherein said means for rotating includes a vacuum chuck for attaching to said wafer.

7. An apparatus as in claim 3 wherein said means for rotating includes a stepper motor.

8. An apparatus as in claim 7 wherein said means for rotating further includes a vacuum chuck having a longitudinal axis coinciding with said axis of rotation.

9.    An apparatus as in claim 8 wherein said means for rotating includes means for said stepper motor to rotate said vacuum chuck.

10.    An apparatus as in claim 9 wherein said means for rotating further includes means for microstepping said stepper motor so that one step of said stepper motor produces a rotation less than or equal to $(1/4)°$ of said vacuum chuck about said longitudinal axis.

11.    A method for orienting a wafer having a curve indented into the generally circular periphery of said wafer, said method comprising:

providing a sensor;

positioning said wafer so that said sensor is located on one side of a planar surface of said wafer near said periphery;

rotating said wafer in a first selected direction about an axis perpendicular to said planar surface until a first point on said indented curve is detected by said sensor to be in register with said sensor; and then

rotating said wafer in a second selected direction about said axis until a second point on said indented orientation curve is detected by said sensor to be in registger with said sensor.

12.    The method of claim 11 wherein said axis passes through the center of said planar surface.

13.    The method of claim 11 wherein said indented curve is a wafer flat.

14.    The method of claim 11 wherein said indented curve is a notch in said wafer.

15. The method of claim 11 wherein providing said sensor comprises providing a sensor having a bifurcated fiber-optic bundle.

16. The method of claim 11 wherein said providing said sensor comprises providing a sensor having a detector and an emitter and said positioning comprises positioning said wafer so that said detector is located on one side of said planar surface of said wafer and said emitter is located on the other side of said planar surface of said wafer.

17. The method of claim 11 further including the step of rotating said wafer through a selected angle in a selected direction from the position where said second point on said indented curve is detected to be in register with said sensor.

FIG.1

FIG.2

FIG.3

FIG.4

FIG.5

4/6

0246117

FIG.6

FIG.7a

FIG.7b

FIG.7c

FIG.8                ZERO DEGREE LINE